# EUROPEAN PATENT SPECIFICATION

(11) **EP 4 059 140 B1**
(45) Date of publication and mention of the grant of the patent: **25.06.2025**
(21) Application number: 20799747.9
(22) Date of filing: 05.11.2020
(51) Int. Cl.: H03L 7/091, G10L 25/90, H03L 7/20, H03L 7/099

(54) **CIRCUIT AND METHOD FOR MODELLING AND EMULATING THE PITCH PERCEPTION OF COMPLEX SOUNDS**
SCHALTUNG UND VERFAHREN ZUR MODELLIERUNG UND EMULATION DER TONHÖHENWAHRNEHMUNG KOMPLEXER TÖNE
CIRCUIT ET PROCÉDÉ DE MODÉLISATION ET D'ÉMULATION DE LA PERCEPTION DE HAUTEUR DE SONS COMPLEXES

(30) Priority: 13.11.2019 IT 201900021111
(43) Date of publication of application: 21.09.2022
(73) Proprietor: Consiglio Nazionale Delle Ricerche, 00185 Roma (IT)
(72) Inventor: GONZALEZ, Diego Luis, 40050 Castello di Serravalle (IT); MAURIZI, Alberto, 40128 BOLOGNA (IT)
(74) Representative: Penza, Giancarlo
(86) International application number: PCT/EP2020/081140
(87) International publication number: WO 2021/094194

(56) References cited:
- US-A- 5 812 737
- PELLE P A: "A Robust Pitch Extraction System Based on Phase Locked Loops", ACOUSTICS, SPEECH AND SIGNAL PROCESSING, 2006. ICASSP 2006 PROCEEDINGS . 2006 IEEE INTERNATIONAL CONFERENCE ON TOULOUSE, FRANCE 14-19 MAY 2006, PISCATAWAY, NJ, USA,IEEE, PISCATAWAY, NJ, USA, vol. 1, 14 May 2006 (2006-05-14), pages I - 249, XP010930163, ISBN: 978-1-4244-0469-8, DOI: 10.1109/ICASSP.2006.1660004
- UDO ZOLZER ET AL: "PLL-based Pitch Detection and Tracking for Audio Signals", INTELLIGENT INFORMATION HIDING AND MULTIMEDIA SIGNAL PROCESSING (IIH-MSP), 2012 EIGHTH INTERNATIONAL CONFERENCE ON, IEEE, 18 July 2012 (2012-07-18), pages 428 - 431, XP032223726, ISBN: 978-1-4673-1741-2, DOI: 10.1109/IIH-MSP.2012.110

## Description

The present invention relates to a circuit and a method for modelling and emulating the pitch perception of complex sounds.

In particular, the present invention relates to a circuit, also called Quasi-Periodic Locked Loop (Q-PLL) that approximates a series of input frequencies with the harmonics of a base frequency also called pseudo-fundamental.

It is known that there is an important problem associated with modelling the perception of complex sounds in auditory devices. In particular, it is very difficult to obtain, with known devices, an exact, stable and efficient emulator of the pitch of complex sounds. This problem affects the analysis and the processing of signals of acoustical interest (*"pitch based processing"*) and prevents from obtaining good performances of electronic ears, very useful for robotics applications and hearing-impaired people.

Document US 5 812 737 discloses a harmonic and frequency-locked loop pitch tracker and sound separation system wherein a quasi-periodic signal is frequency warped by selectively frequency modulating it. The resultant demodulated signal is low pass filtered and the phase is differenced by multiplying the signal with a delayed version of itself. Thereafter the phase difference is measured and the resulting phase error is integrated by an integrator whose output value is the estimate of the frequency. This output frequency parameter is then used to update the demodulating signal thus closing the signal loop.

Document Pelle P. A. "A robust pitch extraction system based on phase locked loops", acoustic, speech and signal processing, 2006, ICASSS 2006 proceedings, 2006 IEEE international conference on Toulouse, France, 14 - 19 May 2006, Piscataway, NY, USA, IEEE, Piscataway, NJ, USA discloses a new scheme for pitch estimation using phase locked loops (PLL) wherein the method is based on a PLL arrange applied to the outputs of a bank of passband filters, each of them tuned to a portion of the spectrum of the signal. PLL devices provide with robust information about the period of the speech signal harmonics and by combining this information with the spectrum of selected portions of the signal, it is possible to determine a reliable estimate of the period of the whole signal.

Document Udo Zolter et al., "PLL-based pitch detection and tracking for audio signal", intelligence information hiding and multimedia signal processing (IIH-MSP), 2012 eighth international conference on, IEEE, 18 July 2012, pages 428 - 431, XP032223726 discloses a phase lock loop based frequency demodulator for pitch detection and tracking of known type.

There is therefore the need to develop an innovative circuit and related method for modelling and emulating the pitch perception of complex sounds with highly efficient performance, thus overcoming the problem of the prior art.

The circuit according to the present invention is a dynamical system that provides a technical solution to a problem of signal processing: finding a frequency, the pseudo-fundamental frequency, whose harmonics best approximate a set of forcing frequencies (input frequencies). The circuit of the present invention is based on the theory of non-linear dynamical systems (n-frequency resonances problem).

These and other objects are fully achieved by virtue of a circuit for modelling and emulating the pitch perception of complex sounds having the characteristics defined in independent claim 1, and by a method for modelling and emulating the pitch perception of complex sounds having the characteristics defined in independent claim 5.

Preferred embodiments of the invention are specified in the dependent claims, whose subject-matter is to be understood as forming an integral part of the present description.

Further characteristics and advantages of the present invention will become apparent from the following description, provided merely by way of a non-limiting example, with reference to the enclosed drawings, in which:
- Figure 1 is a block diagram of a circuit according to the present invention;
- Figure 2 is a graph of the feedback function of an example of the circuit of figure 1;
- Figure 3 is a graph of an example of a Q-PLL behaviour in a quasi-periodic case;
- Figure 4 is a graph of an example of a Q-PLL behaviour in a quasi-periodic case with perturbations of the input signal;
- Figure 5 displays the response diagram of the Q-PLL circuit with the same input as the one of figure 3;
- Figure 6 shows the response for a single frequency input signal as a function of the VCO quiescent frequency; and
- Figure 7 shows the Q-PLL of the present invention applied in an alternative embodiment;
- Figure 8 shows the output signal and the spectrum for a two-carriers modulated signal;
- Figure 9 shows the output signal and the spectrum for a one-carrier only modulated signal; and
- Figure 10 shows a schematic picture of an alternative application of the circuit according to the present invention.

Briefly, the circuit of the present invention represents an extension of the well-known Phase-Locked Loop (PLL) circuit, a circuit largely used in electronics industry. The proposed circuit solves in an effective way the stability problem of a PLL when the forcing signal is a superposition of at least two incommensurable frequencies, *i.e.*, in the case of quasi-periodic input signals.

Solving this problem is fundamental for the implementation of electronic emulators of an auditory system. The Quasi-Periodic Locked Loop pertains to the research area known as qualitative modelling of complex systems. This approach tries to describe the dynamics of a complex system by means of low-dimensional models that capture the most relevant features of the system's dynamics. This approach can be implemented thanks to the typical behavior of complex systems (which are basically non-linear), whose most relevant aspects are:
- i) reduced effective dimensionality (the complex system behaves as if the problem has a number of degrees of freedom much smaller than the real one),
- ii) universal qualitative behavior of the qualitative dynamics (qualitatively the complex system's behavior does not depend on the details of the same), and
- iii) potentially complex solution of the low-dimensional model (deterministic chaos, i.e., a low dimensional model can exhibit a very complex behavior).

The Q-PLL is useful for the application to the human or, more generally, to the mammals' auditory system. In this respect, a particularly relevant result is a model of pitch perception of complex sounds as disclosed in *"*Nonlinear dynamics of the perceived pitch of complex sounds", J. Cartwright, Diego L. Gonzalez and O. Piro, Physical Review Letters, vol. 82, n. 26, pp 5389-5392 (1999*)* and in *"*Pitch perception: A dynamical-systems perspective", J. Cartwright, D.L. Gonzalez and O. Piro, PNAS, vol. 98, n.9, pp. 4855-4859 (2001*).*

The above model is based on a particular kind of dynamical attractors known as three-frequency resonances, as disclosed in *"*Three frequency resonances in dynamical systems", J. Cartwright, D.L. Gonzalez and O. Piro, Int. J. on Bifurcation and Chaos, vol. 9, n. 11, pp. 2181-2187 (1999*).*

Three frequency resonances are particularly interesting because they represent the last stable solution in the Ruelle-Takens-Newhouse scenario for the transition to chaos. Research on this kind of attractors allowed verifying the universality of their hierarchical structure in a parameter space. This behavior has been shown to be universal in different dynamical systems, for example i) a series of coupled oscillators, ii) a forced electronic oscillator, or iii) a discrete circle map.

Despite the universal behavior above cited, an important limitation of these attractors in technological applications, especially in artificial auditory systems, exists. In fact, in all of the studied systems the stability is limited to small intervals in the parameter space (see "Universality in three-frequency resonances", J. Cartwright, D.L. Gonzalez and O. Piro, Physical Review E, Vol. 59, n. 3, 2902-2906 (1999*)).*

Therefore, from the point of view of auditory applications, the fundamental problem is to find how these intervals can be extended while maintaining the dynamical features of the original system.

It can be noted that one of the systems that exhibit three-frequency resonances is a system of two coupled Phase-Locked Loops (PLL) (see "Three-frequency resonances in coupled phase-locked loops", O. Calvo, J. Cartwright, D.L. Gonzalez, O. Piro and F. Sportolari, IEEE Transactions on Circuits and Systems-I: Fundamental Theory and Applications, vol. 47, n. 4, pp. 491-497, (2000*)*)*.*

This suggests that the stability problem can be studied in the framework of an electronics approach.

Specifically, the three-frequency stability problem can be defined in terms of a frequency locked circuit that, in contrast to a standard PLL, remains stable when forced with a quasi-periodic signal with two incommensurate frequency components. Moreover, the locked frequency must be deterministic and equal to one of the possible solutions given by the general theory based on the continued fraction expansion of the input frequency ratio (see *"*Universality in three-frequency resonances", J. Cartwright, D.L. Gonzalez and O. Piro, Physical Review E, Vol. 59, n. 3, 2902-2906 (1999*)).*

PLL circuits represent the state-of-the-art in this field. In spite of this, even the most advanced implementations present a stability problem when the input signal is perturbed by noisy or deterministic frequencies. This fact strongly limits the application of PLLs in the case of highly noisy signals or signals containing non-harmonic partials of a fundamental frequency.

The Q-PLL circuit of the present invention is a feedback system that implements three-frequency resonator dynamics.

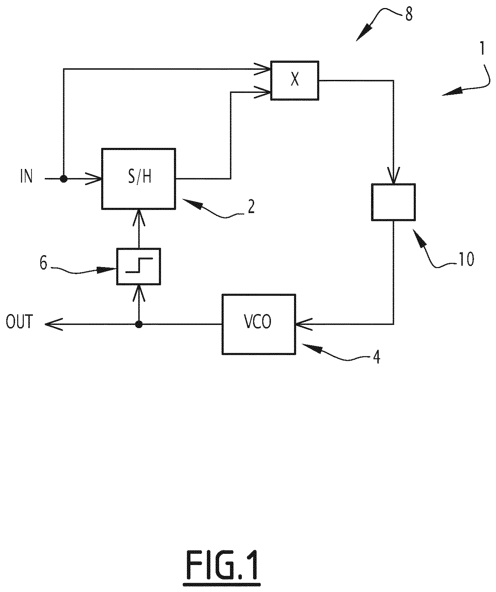

Figure 1 shows a block diagram of a circuit 1 according to the present invention. The circuit 1 is a Q-PLL circuit.

A quasi-periodic input signal IN is sent, by an impulse generator, to a sample and hold 2, thus obtaining a sampled signal. The sampling frequency is determined by a voltage-controlled oscillator (VCO) 4 with quiescent frequency f0, whose output signal OUT is sent to a discretization block 6 and then, in turn, to the sample and hold 2. The discretization block 6 is implemented as a sign function. The discretization block 6 is arranged to discretize the signal coming from the voltage-controlled oscillator 4.

The sampled signal is then multiplied in a multiplier 8 by the non-sampled input signal IN, thus obtaining a multiplied signal, and, subsequently, said multiplied signal is sent to a low-pass filter 10 to be filtered, thus obtaining a filtered signal. Preferably, the low pass filter 10 is implemented via a signal integrator.

The filtered signal is then sent to the VCO 4. The response frequency of the system is the output signal OUT of the VCO. The output signal of the VCO enters the discretization block 6, thus obtaining in output a discretized signal.

The discretized signal makes the VCO frequency to lock to one of possible solutions corresponding to three-frequency resonances, associated in a manner per se known to a quasi-periodic signal, which are organized in hierarchical way, i.e., main resonances of the system are selected while those of higher order are typically discarded. The main resonances are defined by fR = (f1+f2)/(p+q) where p/q is one of the possible convergents (continued fraction approximants) of f1/f2.

Because the sampled signal includes aliasing components of the same frequency of the input signal, their product generates constant terms that can renormalize the frequency of the VCO 4 and synchronize it to a specific frequency among the main three-frequency resonances. The main resonance fR is selected in a large interval of f0 (the quiescent frequency of the VCO) around the value of fR. When the response frequency equals a three-frequency resonance, these above-mentioned constant terms depend(s) on the VCO phase that acts as a virtual phase. In a full cycle of the oscillator phase, the response phase oscillates a number of times, which is the sum of the integer coefficients of the three-frequency resonance, p and q.

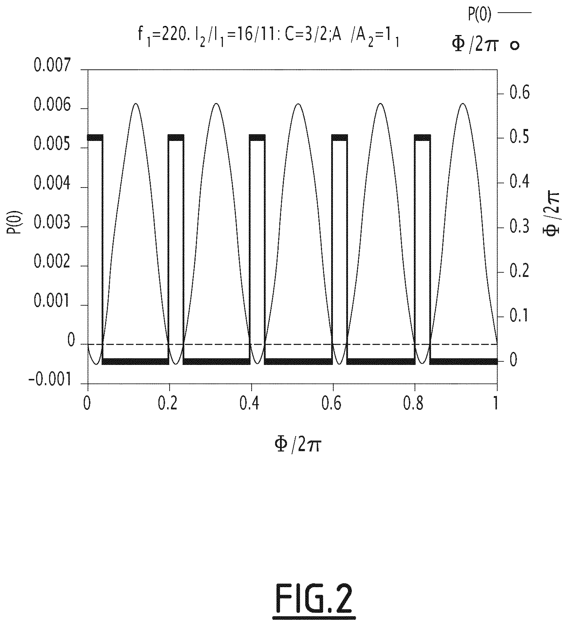

As an example (see figure 2), for an input frequency ratio of 2:3, the feedback function oscillates five times for one full cycle of the VCO 4. This virtual phase allows to select the correct value of feedback that stabilizes the main three-frequency resonance, in this case characterized by a frequency (f1+f2)/(2+3), as detailed here below.

The Q-PLL circuit 1 of the present invention can be implemented in different ways and with different technical solutions in a manner per se known, for example with a software or with an analogic electronic circuit.

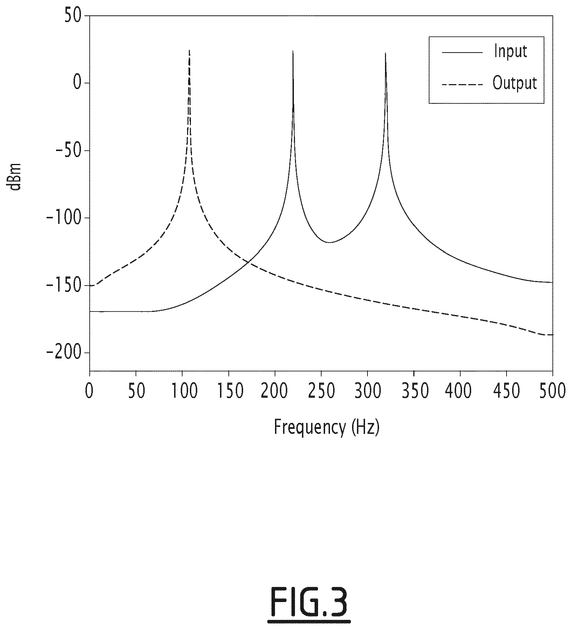

Figure 3 shows a graph of an example of a Q-PLL behaviour in a quasi-periodic case wherein the intput signal IN is a combination of two signals whose respective frequencies have a ratio near 2:3.

Based on the three-frequency resonances theory, the frequency of the output signal OUT should be equal to (f1+f2)/(2+3). In the case of figure 3, the input signal IN is the sum of two sinusoids of predetermined frequency f1 and f2, for example 220 Hz and 320 Hz.

The theoretical response should be an output signal OUT having a frequency of 108 Hz, and this is what can be effectively observed in figure 3.

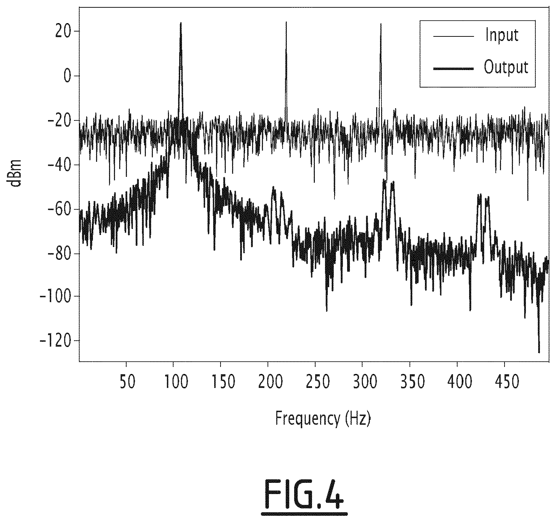

In figure 4, despite the fact that the input signal IN is perturbed by the superposition of white noise, the frequency of the output signal OUT still matches the theoretical value of 108 Hz.

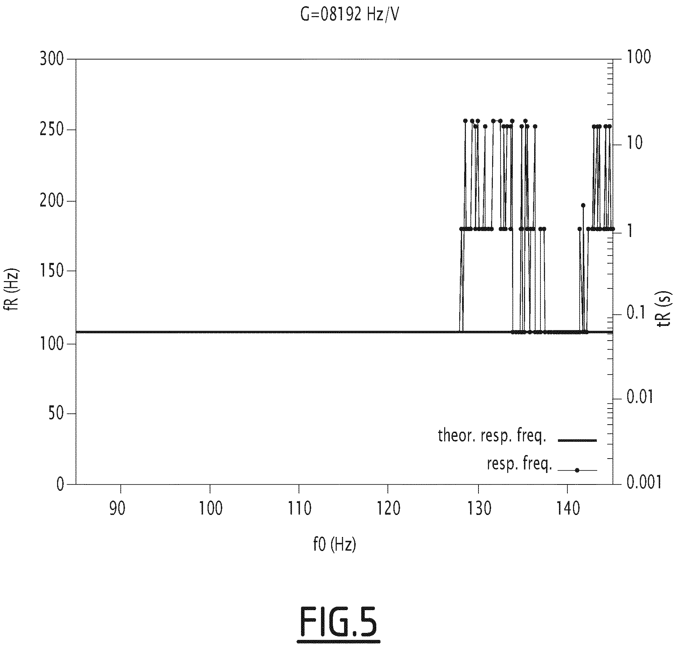

Figure 5 displays the response diagram of the Q-PLL circuit 1 with the same input as the one of figure 3, as a function of the quiescent frequency f0 of the VCO 4. A remarkable fact is that the circuit response coincides with the theoretical one in a large range of the control parameter f0 (in the case of figure 5, between 90 Hz and 130 Hz) demonstrating the ability of the Q-PLL circuit 1 to overcome the stability problem usually present in similar dynamical systems.

In the Q-PLL circuit 1 all the higher order resonances disappears and only the main resonance survives in a very large range of the parameters. It worth noting that this response is stable if the input is perturbed, e.g., by white noise or other deterministic, non-harmonic, frequencies (not reported).

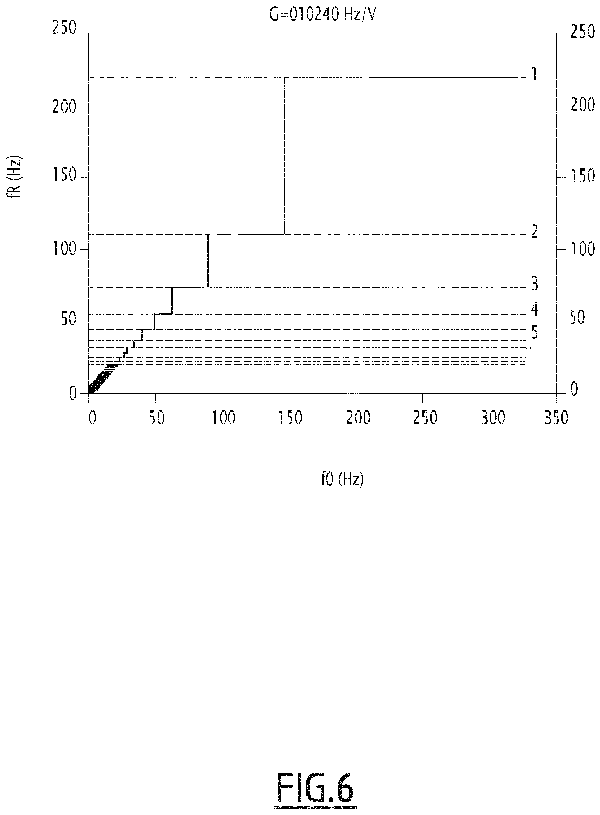

An additional feature is that, in the limiting case of a periodic input, the Q-PLL circuit 1 behaves as a frequency divider, producing different subharmonics of the input as a function of the quiescent frequency f0 (see figure 6, which shows the response for a single frequency input signal as a function of the VCO quiescent frequency). Such behavior demonstrates that, in case of a single frequency input signal, the Q-PLL behaves as a sub-harmonic PLL, that locks at the input frequency and its subharmonics, depending on the quiescent frequency f0.

An analog electronic version of the circuit 1 can also be created, for example by using analog or mixed circuits such as, for example, an *AD633* device as multiplier 8, a *LF356* device as low-pass filter 10, a 555 device as impulse generator, a *LF398* device as sample and hold 2, and a *CD4046* device as VCO 4.

The main advantages of the circuit of the present invention are the followings:
- it allows performing an efficient and robust determination of the pseudo-fundamental of a plurality of input frequencies;
- it emulates the perception of the pitch of complex sound by the auditive function;
- it extends the structural stability to a larger interval of control parameters with respect to existing circuits;
- it maintains the stability in the case of deterministic (quasi-periodic) and random (noise) perturbations of the input signal;
- it represents a qualitative improvement of the typical PLLs;
- it can be implemented on different platforms: analog, digital or mixed electronics, software, all-digital, etc.

As an alternative embodiment of the present invention, the circuit above disclosed is useful also in a different application, as here below detailed.

Cellular communications require high data transmission capability and rates and a more reliable link.

Regarding reliability, wireless communication channels suffer from various factors, for example, path loss, *i.e.* the power loss due to radio signal propagation, and fading (a phenomenon which combines the effect of multiple propagation paths, the presence of shadows/reflections in such paths, and rapid movement of mobile units).

Channel fading represents the major impairment. For tackling this problem, powerful *diversity communication* techniques providing wireless link reliability at relatively low cost have been developed.

Diversity techniques basically provide two or more inputs to the receiver. If one radio path undergoes deep fade, another independent path may provide an alternative strong signal.

Diversity techniques can be classified according to:
- space diversity: using antennas spaced enough (at the transmitter or receiver device);
- time diversity: repeatedly transmitting information at a time spacing that exceeds the coherence time of the channel;
- polarization diversity: using antennas of different polarization, *i.e.,* horizontal and vertical;
- frequency diversity: transmitting a same information on more than one carrier frequency.
In particular, an important advantage for frequency diversity is that only one antenna is needed. However, in the classical implementation, at least two independent receivers are required. For example, in frequency modulated transmissions, usual demodulation techniques don't allow simultaneous synchronization to two or more arbitrary carrier frequencies. Thus, a number of independent receivers, equal to the number of different frequency carriers, are needed. The classical example is the demodulation by PLLs.

On the contrary, the Q-PLL circuit of the present invention allows to synchronize simultaneously to two arbitrary frequencies than, in turn, can be used as independent carriers. For example, with the same configuration and parameters above disclosed with reference to figures 1 and 2, the circuit can be used for demodulating simultaneously two modulated carriers.

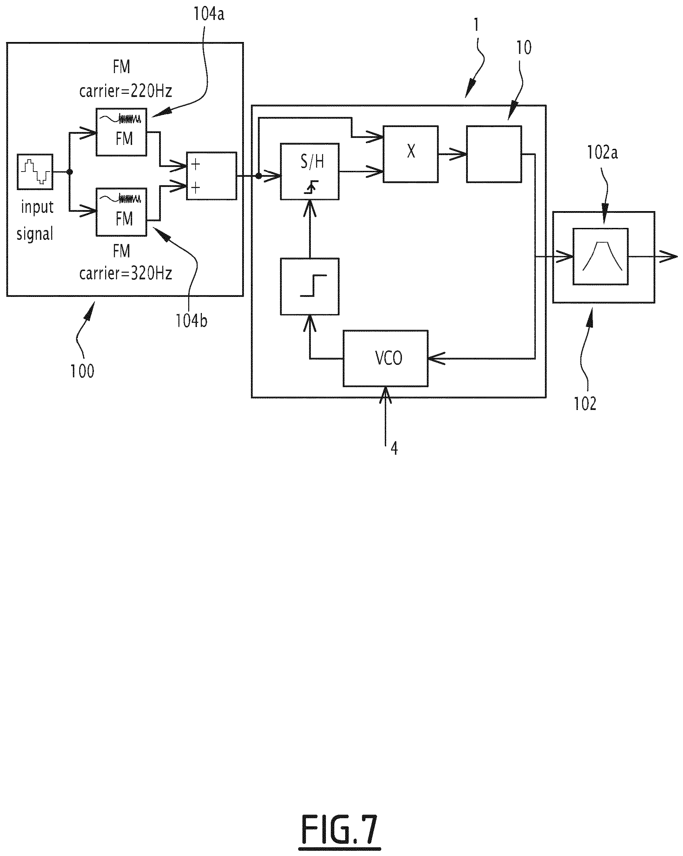

In Figure 7, an input module 100 and an output module 102 of a Q-PLL circuit 1 according to the present invention are shown. A first and a second independent carrier (in the example, having frequency of 220Hz and 320Hz, respectively) are modulated in respective modulating modules 104a, 104b, by a same input signal (in this example a sinusoidal signal).

The filtered signal coming out from the low-pass filter 10 of the circuit 1 is sent to the output module 102, which comprises a band-pass filter 102a, arranged to filter the filtered signal to obtain a final demodulated signal.

The demodulated signal is the input of the VCO 4.

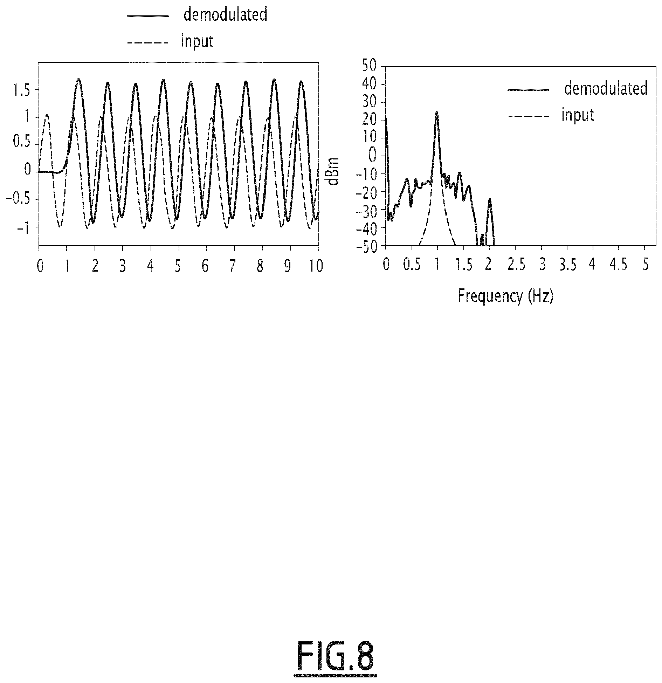

It has been demonstrated that the Q-PLL circuit 1 applied in the alternative embodiment of Figure 7 demodulates correctly the simultaneously modulated inputs (see figure 8 which shows on the left the output signal and on the right the spectrum for a two-carriers modulated signal).

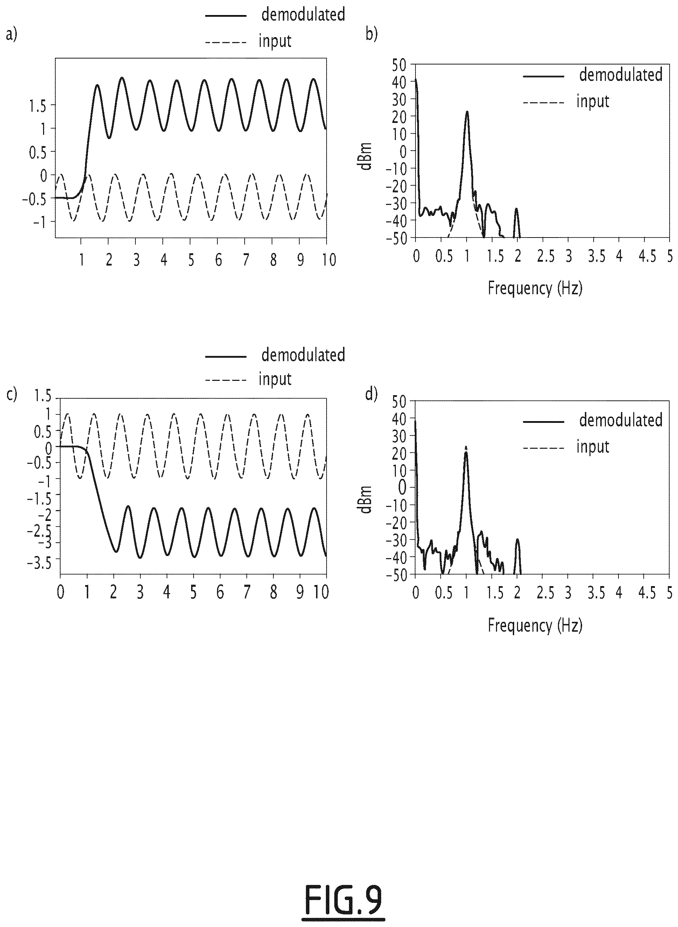

In Figure 9, it is shown the output signal and the spectrum for a one-carrier only modulated signal. Figures 9(a) and 9(b) refer to the first carrier at 220Hz, the figures 9(c) and 9(d) refer to the second carrier at 320Hz.

These graphs show that, if one of the carriers is suppressed, the system continues to demodulate correctly synchronizing to a sub-harmonic of the surviving carrier.

This demonstrates that the Q-PLL circuit is able to demodulate correctly even when one of the carriers is faded.

This potentially reduces by a factor of two the number of required demodulating systems in a diversity frequency implementation.

The above example demonstrates the potentiality of the Q-PLL circuit to extend the classical PLL applications. The alternative embodiment here below disclosed can be summarized as follows:
- circuit for modeling communication signals comprising:
- a sample and hold (2) arranged to receive and sample an input signal (IN) comprising two modulated carriers with arbitrary frequencies, in general quasi-periodic, thus obtaining a sampled signal;
- a multiplier (8), connected to the sample and hold (2), arranged to multiply the input signal (IN) with the sampled signal, thus obtaining a multiplied signal;
- a low-pass filter (10), connected to the multiplier (8), arranged to filter the multiplied signal, thus obtaining a filtered signal;
- a band-pass filter (102a), connected to the low-pass filter (10), arranged to filter the demodulated signal;
- a voltage control oscillator (4), connected to the low-pass filter (10), arranged to produce a signal with frequency determined by its input signal;
- a discretization block (6), connected to the voltage control oscillator (4), arranged to discretize the output signal, thus obtaining a discretized signal, said discretized signal being arranged to enter the sample and hold (2) to determine the sampling frequency of the sample and hold (2);
wherein the filtered signal makes the VCO frequency to lock to one of predetermined three-frequency resonances.

The above disclosed circuit can be used also in the following application.

A diversity of technical devices using innovative materials require often the use of non-invasive methods for early detection of defects, faults, or cracks that can compromise their normal functioning. Particularly critical applications are represented by nuclear, thermal, and hydroelectric centrals, as well as by blades for aeronautic turbines and other critical aero-spatial applications.

Another sector for which early detection of faults represents an important technological challenge is represented by constructions in reinforced concrete, which can degrade due to aging and corrosion processes.

Not of minor importance are medicine-related applications where, for example, non-invasive techniques are relevant for detecting fractures in bones.

One of the most powerful techniques for approaching such problems consists in the use of ultrasound for exploring the properties and the aging of the involved materials.

The state of the art in this field is represented by nonlinear ultrasound methods, that take advantage of the nonlinear behavior caused by the presence of defects for identifying them (see for example D. Broda, W.J.Staszewski, A.Martowicz, T.Uhl, V.V.Silberschmidt, "Modelling of nonlinear crack-wave interactions for damage detection based on ultrasound"-A review, Journal of Sound and Vibration 333, 1097-1118 (2014); C. Payan, V. Garnier, J. Moysan, "Potential of nonlinear ultrasonic indicators for NonDestructive Testing of concrete. Advances in Civil Engineering", Hindawi Publishing Corporation, pp.238472 (2010); Marie Mullera, Alexander Sutinb, Robert Guyerc, Maryline Talmantd, Pascal Laugiere, and Paul A. Johnson, "Nonlinear resonant ultrasound spectroscopy (NRUS) applied to damage assessment in bone", J. Acoust. Soc. Am. 118, 6, (2005); and Frank Mevissen and Michele Meo, "A Nonlinear Ultrasonic Modulation Method for Crack Detection in Turbine Blades", Aerospace 7, 72, (2020)).

The most advanced techniques use multifrequency ultrasound excitation of the sample and, in some cases, allow to investigate dynamic properties of materials (see for example Igor Solodov, Nils Krohn, Gerhard Busse, "Nonlinear ultrasonic NDT for early defect recognition and imaging", 10th European Conference on NonDestructive Testing, Moscow 2010, June 7-11 (ECNDT 2010).

Thus, the Q-PLL circuit 1 of the present invention represents an advance for the technological instruments for ultrasound nondestructive analysis of material.

Moreover, as the properties of response of material defects to ultrasound excitations is still a matter of research, the Q-PLL circuit 1 of the present invention represents also an improvement in the field of scientific instrumentation, being able to detect and identify the presence of generic dynamic resonances in response to quasi-periodic excitation signals.

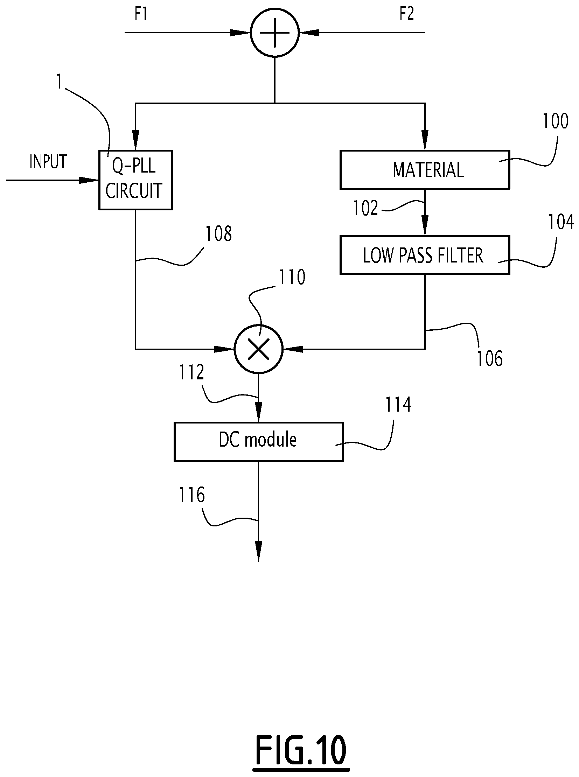

Figure 10 schematically shows these applications.

A Q-PLL circuit 1 has a quiescent frequency f0, as above disclosed, which is externally controlled. The Q-PLL circuit 1 is fed with two excitation signals having respective frequencies f1 and f2. The two excitation signals are also sent to a material of interest 100 (usually the inputs are available as an electric signal that, after amplification, excites the ultrasound transducers).

As a result, all the main three-frequency resonances associated with these frequencies can be produced in a controlled way.

Using methods of comparison per se known, the presence of such main three frequencies in a sample response can be identified.

In particular, the two excitation signals are sent to excite a material 100, and a response signal 102 is obtained.

Such response signal 102 is then filtered with a low-pass filter 104, with a cutoff frequency below the lesser of the two frequencies f1 and f2, thus obtaining a filtered signal 106.

The filtered signal 106 is at this point multiplied with an output signal 108 coming from the Q-PLL circuit 1, in a multiplying block 110, thus obtaining an output complex signal 112.

The output complex signal 112 is finally sent to a Direct Current (DC) detection module 114, arranged to extract, from said output complex signal 112, the DC component, thus outputting a final signal 116 corresponding to the amplitude of such DC component.

Only when a frequency component of the same value that such of the frequency of the main resonance is present in the response, the final signal 116 is a non-zero signal.

The amplitude of this non-zero signal is proportional to the amplitude of the frequency component in the response of the material equal to the frequency of the main resonance.

Thus, the final signal 116 gives information about the dynamic characteristics of the material when excited with two different ultrasound frequency components.

From the point of view of signal-to-noise ratio, such operation can be done with great advantage. This is because the three-frequency resonance is always below the forcing frequencies and, thus, a simple low-pass filter 106 can be applied to the sample response prior to the multiplication, without affecting the results and improving notably the signal-to-noise ratio.

By scanning the quiescent frequency f0 of the Q-PLL circuit 1 by means of an externally controlled parameter, it can be detected the presence in the sample response of all the main resonances associated with the two frequencies f1 and f2 of the forcing.

By varying these excitation frequencies, additional information can be obtained about the persistence of the resonances in the parameter space and, thus, about the characteristic of the faults under investigation; this possibility has not been explored from a scientific point of view.

Clearly, the principle of the invention remaining the same, the embodiments and the details of production can be varied considerably from what has been described and illustrated purely by way of non-limiting examples, without departing from the scope of protection of the present invention as defined by the attached claims.

## Claims

1. Circuit for modelling and emulating the pitch perception of complex sounds comprising:
- a sample and hold circuit (2) arranged to receive and sample a quasi-periodic input signal (IN) comprising at least two predetermined frequencies (f1, f2), thus obtaining a sampled signal;
- a multiplier (8), connected to the sample and hold circuit (2), arranged to multiply the input signal (IN) with the sampled signal, thus obtaining a multiplied signal;
- a low-pass filter (10), connected to the multiplier (8), arranged to filter the multiplied signal, thus obtaining a filtered signal;
- a voltage controlled oscillator (4), connected to the low-pass filter (10), arranged to provide an output signal emulating the pitch of the quasi-periodic input signal (IN);
- a discretization block (6), connected to the voltage control oscillator (4), arranged to discretize the output signal, thus obtaining a discretized signal, said discretized signal being arranged to enter the sample and hold circuit (2) in order to provide the sampling frequency of the sample and hold circuit (2);
wherein the filtered signal makes the voltage control oscillator frequency lock to a main resonance frequency of the circuit fR = (f1+f2)/(p+q) which is based on the three-frequency resonances theory, where f1 and f2 are the two predetermined frequencies, and p/q is one of the possible convergent of f1/f2, and wherein the frequency of the output signal of the voltage controlled oscillator is equal to the main resonance frequency.

2. The circuit of claim 1, wherein the low pass filter (10) is a signal integrator.

3. The circuit of claim 1 or 2, wherein the multiplier (8) is an AD633 device, the low-pass filter (10) is a LF356 device, the impulse generator is a 555 device, the sample and hold circuit (2) is a LF398 device, and the voltage-controlled oscillator (4) is a CD4046 device.

4. The circuit of any of the preceding claims, wherein the product of the input and sampled signals generates constant terms arranged to renormalize the frequency of the voltage control oscillator (4) and synchronize it to the main resonance of the circuit.

5. Method for modelling the perception of complex sounds comprising:
- sending to a sample and hold circuit (2) a quasi-periodic input signal (IN) comprising at least two predetermined frequencies (f1, f2), thus obtaining a sampled signal;
- multiplying, through a multiplier (8) connected to the sample and hold circuit (2), the input signal (IN) with the sampled signal, thus obtaining a multiplied signal;
- filtering, through a low-pass filter (10) connected to the multiplier (8), the multiplied signal, thus obtaining a filtered signal;
- obtaining, through a voltage control oscillator (4) connected to the low-pass filter (10), an output signal emulating the pitch of the quasi-periodic input signal (IN);
- discretizing, through a discretization block (6) connected to the voltage control oscillator (4), the output signal, thus obtaining a discretized signal, said discretized signal being arranged to enter the sample and hold circuit (2) and being the sampling frequency of the sample and hold circuit (2);
wherein the filtered signal makes the voltage control oscillator frequency lock to a main resonance frequency of the circuit fR = (f1+f2)/(p+q) which is based on the three-frequency resonances theory, where f1 and f2 are the two predetermined frequencies, and p/q is one of the possible convergent of f1/f2, and wherein the frequency of the output signal of the voltage controlled oscillator is equal to the main resonance frequency.

## Patentansprüche

1. Schaltung zur Modellierung und Emulation der Tonhöhenwahrnehmung komplexer Töne, umfassend:
- eine Abtast- und Halteschaltung (2), die angeordnet ist, um ein quasi-periodisches Eingangssignal (IN) zu empfangen und abzutasten, das mindestens zwei vorbestimmte Frequenzen (f1, f2) umfasst, wodurch ein abgetastetes Signal erhalten wird;
- einen Multiplizierer (8), der mit der Abtast- und Halteschaltung (2) verbunden ist und angeordnet ist, um das Eingangssignal (IN) mit dem abgetasteten Signal zu multiplizieren, wodurch ein multipliziertes Signal erhalten wird;
- ein Tiefpassfilter (10), das mit dem Multiplizierer (8) verbunden ist und angeordnet ist, um das multiplizierte Signal zu filtern, wodurch ein gefiltertes Signal erhalten wird;
- einen spannungsgesteuerten Oszillator (4), der mit dem Tiefpassfilter (10) verbunden ist und so angeordnet ist, dass er ein Ausgangssignal bereitstellt, das die Tonhöhe des quasiperiodischen Eingangssignals (IN) emuliert;
- einen Diskretisierungsblock (6), der mit dem Spannungssteuerungsoszillator (4) verbunden ist und angeordnet ist, um das Ausgangssignal zu diskretisieren, wodurch ein diskretisiertes Signal erhalten wird, wobei das diskretisierte Signal angeordnet ist, um in die Abtast- und Halteschaltung (2) einzutreten, um die Abtastfrequenz der Abtast- und Halteschaltung (2) bereitzustellen;
wobei das gefilterte Signal die Frequenz des Spannungssteuerungsoszillators auf eine Hauptresonanzfrequenz der Schaltung fR = (f1+f2)/(p+q) sperrt, die auf der Drei-Frequenz-Resonanztheorie basiert, wobei f1 und f2 die beiden vorbestimmten Frequenzen sind und p/q eine der möglichen Konvergenz von f1/f2 ist, und wobei die Frequenz des Ausgangssignals des spannungsgesteuerten Oszillators gleich der Hauptresonanzfrequenz ist.

2. Schaltung nach Anspruch 1, wobei das Tiefpassfilter (10) ein Signalintegrator ist.

3. Schaltung nach Anspruch 1 oder 2, wobei der Multiplizierer (8) eine AD633-Vorrichtung ist, das Tiefpassfilter (10) eine LF356-Vorrichtung ist, der Impulsgenerator eine 555-Vorrichtung ist, die Abtast- und Halteschaltung (2) eine LF398-Vorrichtung ist und der spannungsgesteuerte Oszillator (4) eine CD4046-Vorrichtung ist.

4. Schaltung nach einem der vorhergehenden Ansprüche, wobei das Produkt der eingegebenen und abgetasteten Signale konstante Werten erzeugt, die angeordnet sind, um die Frequenz des Spannungssteuerungsoszillators (4) zu renormieren und ihn mit der Hauptresonanz der Schaltung zu synchronisieren.

5. Verfahren zur Modellierung der Wahrnehmung komplexer Töne, umfassend:
- Senden eines quasiperiodischen Eingangssignals (IN), das mindestens zwei vorbestimmte Frequenzen (f1, f2) umfasst, an eine Abtast- und Halteschaltung (2), wodurch ein abgetastetes Signal erhalten wird;
- Multiplizieren des Eingangssignals (IN) mit dem abgetasteten Signal durch einen Multiplizierer (8), der mit der Abtast- und Halteschaltung (2) verbunden ist, wodurch ein multipliziertes Signal erhalten wird;
- Filtern des multiplizierten Signals durch ein Tiefpassfilter (10), das mit dem Multiplizierer (8) verbunden ist, wodurch ein gefiltertes Signal erhalten wird;
- Erhalten, durch einen Spannungssteuerungsoszillator (4), der mit dem Tiefpassfilter (10) verbunden ist, eines Ausgangssignals, das die Tonhöhe des quasi-periodischen Eingangssignals (IN) emuliert;
- Diskretisieren des Ausgangssignals durch einen Diskretisierungsblock (6), der mit dem Spannungssteuerungsoszillator (4) verbunden ist, wodurch ein diskretisiertes Signal erhalten wird, wobei das diskretisierte Signal so angeordnet ist, dass es in die Abtast- und Halteschaltung (2) eintritt und die Abtastfrequenz der Abtast- und Halteschaltung (2) ist;
wobei das gefilterte Signal die Frequenz des Spannungssteuerungsoszillators auf eine Hauptresonanzfrequenz der Schaltung fR = (f1+f2)/(p+q) sperrt, die auf der Drei-Frequenz-Resonanztheorie basiert, wobei f1 und f2 die beiden vorbestimmten Frequenzen sind und p/q eine der möglichen Konvergenz von f1/f2 ist, und wobei die Frequenz des Ausgangssignals des spannungsgesteuerten Oszillators gleich der Hauptresonanzfrequenz ist.

## Revendications

1. Circuit de modélisation et d'émulation de la perception de hauteur de sons complexes, comprenant :
- un échantillonneur-bloqueur (2) conçu pour recevoir et échantillonner un signal d'entrée (IN) quasi-périodique comprenant au moins deux fréquences prédéterminées (f1, f2) et obtenir ainsi un signal échantillonné ;
- un multiplicateur (8), relié à l'échantillonneur-bloqueur (2), conçu pour multiplier le signal d'entrée (IN) par le signal échantillonné et obtenir ainsi un signal multiplié ;
- un filtre passe-bas (10), relié au multiplicateur (8), conçu pour filtrer le signal multiplié et obtenir ainsi un signal filtré ;
- un oscillateur à tension asservie (4), relié au filtre passe-bas (10), conçu pour fournir un signal de sortie émulant la hauteur du signal d'entrée (IN) quasi-périodique ;
- un bloc de discrétisation (6), relié à l'oscillateur à tension asservie (4), conçu pour discrétiser le signal de sortie et obtenir ainsi un signal discrétisé, ledit signal discrétisé étant conçu pour entrer dans l'échantillonneur-bloqueur (2) afin de fournir la fréquence d'échantillonnage de l'échantillonneur-bloqueur (2) ;
dans lequel le signal filtré fait en sorte que la fréquence de l'oscillateur à tension asservie se verrouille sur une fréquence de résonance principale du circuit fR = (f1+f2)/(p+q) qui est basée sur la théorie des résonances à trois fréquences, où f1 et f2 sont les deux fréquences prédéterminées, et p/q est l'un des convergents possibles de f1/f2, et dans lequel la fréquence du signal de sortie de l'oscillateur à tension asservie est égale à la fréquence de résonance principale.

2. Circuit selon la revendication 1, dans lequel le filtre passe-bas (10) est un intégrateur de signaux.

3. Circuit selon la revendication 1 ou 2, dans lequel le multiplicateur (8) est un dispositif AD633, le filtre passe-bas (10) est un dispositif LF356, le générateur d'impulsions est un dispositif 555, l'échantillonneur-bloqueur (2) est un dispositif LF398 et l'oscillateur à tension asservie (4) est un dispositif CD4046.

4. Circuit selon l'une quelconque des revendications précédentes, dans lequel le produit des signaux d'entrée et échantillonnés génère des termes constants conçus pour renormaliser la fréquence de l'oscillateur à tension asservie (4) et à la synchroniser avec la résonance principale du circuit.

5. Procédé de modélisation de la perception de sons complexes, comprenant :
- envoyer à l'échantillonneur-bloqueur (2) un signal d'entrée (IN) quasi-périodique comprenant au moins deux fréquences prédéterminées (f1, f2) et obtenir ainsi un signal échantillonné ;
- multiplier, par un multiplicateur (8) relié à l'échantillonneur-bloqueur (2), le signal d'entrée (IN) avec le signal échantillonné et obtenir ainsi un signal multiplié ;
- filtrer, par l'intermédiaire d'un filtre passe-bas (10) relié au multiplicateur (8), le signal multiplié et obtenir ainsi un signal filtré ;
- obtenir, par l'intermédiaire d'un oscillateur à tension asservie (4) relié au filtre passe-bas (10), un signal de sortie émulant la hauteur du signal d'entrée (IN) quasi-périodique ;
- discrétiser, par l'intermédiaire d'un bloc de discrétisation (6) relié à l'oscillateur à tension asservie (4), le signal de sortie et obtenir ainsi un signal discrétisé, ledit signal discrétisé étant conçu pour entrer dans l'échantillonneur-bloqueur (2) et étant la fréquence d'échantillonnage de l'échantillonneur-bloqueur (2) ;
dans lequel le signal filtré fait en sorte que la fréquence de l'oscillateur à tension asservie se verrouille sur une fréquence de résonance principale du circuit fR = (f1+f2)/(p+q) qui est basée sur la théorie des résonances à trois fréquences, où f1 et f2 sont les deux fréquences prédéterminées, et p/q est l'un des convergents possibles de f1/f2, et dans lequel la fréquence du signal de sortie de l'oscillateur à tension asservie est égale à la fréquence de résonance principale.
